# EUROPÄISCHE PATENTSCHRIFT

(11) **EP 3 257 340 B1**
(45) Veröffentlichungstag und Bekanntmachung des Hinweises auf die Patenterteilung: **19.12.2018**
(21) Anmeldenummer: 16712194.6
(22) Anmeldetag: 28.01.2016
(51) Int. Cl.: H05K 5/00

(54) **ZWEITEILIGES GEHÄUSE ZUR AUFNAHME EINER ELEKTRONISCHEN BAUGRUPPE**
TWO-PART HOUSING FOR RECEIVING AN ELECTRONIC ASSEMBLY
BOÎTIER EN DEUX PARTIES DESTINÉ À RECEVOIR UN MODULE ÉLECTRONIQUE

(30) Priorität: 09.02.2015 DE 102015202212
(43) Veröffentlichungstag der Anmeldung: 20.12.2017
(73) Patentinhaber: Continental Automotive GmbH, 30165 Hannover (DE)
(72) Erfinder: CHRISTOPH, Markus, 93055 Regensburg (DE); PLANKL, Christian, 93055 Burgweinting (DE); PROBST, Heinrich, 93093 Donaustauf (DE)
(74) Vertreter: Büchner, Jörg
(86) Internationale Anmeldenummer: PCT/DE2016/200055
(87) Internationale Veröffentlichungsnummer: WO 2016/127989

(56) Entgegenhaltungen:
- DE-C1- 19 742 458
- US-A1- 2012 026 703

## Beschreibung

Die Erfindung betrifft ein zweiteiliges Gehäuse gemäß dem Oberbegriff von Anspruch 1.

Elektronische Baugruppen werden insbesondere in der Automobilindustrie zunehmend mit Kunststoffgehäusen ausgeführt, da diese neben der relativ einfachen und kostengünstigen Herstellung insbesondere erheblich leichter sind, wodurch wiederum der Spritverbrauch sinkt. Zur Befestigung des Kunststoffgehäuses an einem Trägerkörper weist das Kunststoffgehäuse im Allgemeinen einen Montageflansch mit einer Öffnung auf. Da jedoch der Montageflansch des Kunststoffgehäuses an der Öffnung durch Montagekräfte, beispielsweise beim Verschrauben oder Vernieten, sowie im späteren Betrieb des Fahrzeugs durch Erschütterungen und dergleichen mechanisch beansprucht wird, andererseits aber nicht verformt oder gar beschädigt werden darf, wird eine Befestigungshülse, üblicherweise ein Metalleinlegeteil, zur Erhöhung der übertragbaren Kräfte in die Öffnungen des Montageflansch eingesetzt.

Aus der DE 19742458 C1 ist darüber hinaus ein Kunststoffgehäuse bekannt, bei welchem eine metallische Befestigungshülsen im Montageflansch über ein ebenfalls metallisches und damit elektrisch leitfähiges Verbindungsteil mit der Leiterplatte im Inneren des Gehäuses verbunden wird, wobei die Befestigungshülsen im Montageflansch als auch das Verbindungsteil vorzugsweise im Kunststoffgehäuse umspritzt werden.

Metallische Gehäuse bieten eine höhere Steifigkeit, welche nicht nur für die Sicherheit der darin befindlichen elektronischen Baugruppe, sondern auch für eine unverfälschte Signalübertragung zu Sensoren auf der Leiterplatte dieser Baugruppe, was je nach Anwendungsfall ebenfalls erwünscht ist. Die DE 102008037278 A1 weist darüber hinaus ein Gehäuse auf, in welchem ein Versteifungsrahmen einsteckbar ist, um eine unverfälschte Signalübertragung zu Sensoren auf der Leiterplatte im Inneren des Gehäuses zu ermöglichen.

Andererseits sind für eine Reihe anderer Anwendungsfälle möglichst entkoppelten Anordnungen von Leiterplatte und Sensoren gerade im Bereich der Automobilelektronik erforderlich, um störende Einflüsse, beispielsweise unebener Fahrbahnbelag oder Steinschlag oder dergleichen nicht zu Fehlfunktionen führen zu lassen.

Airbagsteuergeräte werden in ihrer Komplexität, ihrem Funktionsumfang und den damit verbundenen Anforderungen immer umfangreicher, z.B. durch Integration von Fahrdynamikfunktionen mit den entsprechenden empfindlichen Sensoren. Diese aktiven mikromechanischen Sensoren zur Sensierung von Fahrzeugbewegungszuständen basieren funktional auf internen Elementen mit notwendigen Resonanzeigenschaften. Störende Einflüsse, beispielsweise durch Schottersteinbeschuss durch Radschlupf, generieren Störungen zum Teil im resonanten Frequenzspektrum der Sensoren. In der Folge kommt es zu unerwünschten Störsignalen der Sensoren und zu Funktionseinschränkungen diverser Signalnutzer.

Zur Vermeidung der Beeinflussung der Sensoren ist also eine (möglichst) dämpfende Befestigung der Sensoren bzw. des Steuergerätes erforderlich. So haben sich zum Beispiel Kunststoffgehäuse auch bzgl. der Dämpfung als vorteilhaft erwiesen, schützen die Baugruppe jedoch gerade im Falle eines Fahrzeugcrashs evtl. nicht hinreichend, um einen Datenverlust zu verhindern.

Aus der EP 11 33 413 B1 ist dabei ein Steuergerät für Insassenschutz bekannt, bei welchem das Gehäuse aus Kunststoff hergestellt wird, jedoch einen steifen, aus Metall hergestellten Rahmen enthält, an welchem die Leiterplatte mit dem Sensor unmittelbar angeschraubt wird, so dass der Kunststoff des Gehäuses gerade kein Bestandteil des Signalpfads zum Sensor ist. Diese Anbindung ist daher besonders steif. Der Rahmen kann die Anschraubpunkte enthalten und auch als elektrischer Masseleiter fungieren.

Die Aufgabe der vorliegenden Erfindung ist es, ein zweiteiliges Gehäuse zur Aufnahme einer elektronischen Baugruppe vorzustellen, welches möglichst viele Vorteile dieser unterschiedlichen Konzepte miteinander vereint, insbesondere die widersprüchlichen Anforderungen Entkopplung von Sensoren auf der Leiterplatte von störenden mechanischen Vibrationen einerseits bei gleichzeitiger Stabilität des Gehäuses im Crashfall andererseits gewährleistet.

Diese Aufgabe wird durch die Merkmale der unabhängigen Ansprüche gelöst. Vorteilhafte Weiterbildungen der Erfindung ergeben sich aus den Unteransprüchen, wobei auch Kombinationen und Weiterbildungen einzelner Merkmale miteinander denkbar sind.

Ein wesentlicher Gedanke der Erfindung besteht darin, dass quasi wieder ein Hybridgehäuse als Kombination aus einem Metallgehäuse und einem Kunststoffgehäuse entsteht, indem dieses Gehäuseteil einen Metalleinsatz aufweist, welcher zumindest einen metallischen Rahmen um die einzuschließende Baugruppe bildet und welcher aber zusätzlich zumindest teilweise mit Kunststoff umspritzt ist.

Begrifflich ist der Metalleinsatz bzw. dessen Rahmen funktional zu trennen von der Befestigungshülse, da der Metalleinsatz bzw. dessen Rahmen der Versteifung um die Leiterplatte dient, während die Befestigungshülse im Montageflansch angeordnet ist.

Der Metalleinsatz weist insbesondere einen metallischen Rahmen auf, welcher die einzuschließende Baugruppe zumindest teilweise, vorzugsweise an zumindest 3 umgebenden Seitenflächen umschließt.

Zudem ist der Rahmen des Metalleinsatzes und die zumindest eine Befestigungshülse über eine elektrisch leitfähige Anbindung mit dem Rahmen des Metalleinsatzes verbunden, so dass über einen elektrischen Kontakt zwischen der Leiterplatte und dem Metalleinsatz eine Masseanbindung der Leiterplatte über den Kontakt zu Metalleinsatz und vom Metalleinsatz über die leitfähige Anbindung zur Befestigungshülse und von dieser an einem metallischen Träger, beispielsweise die Fahrzeugkarosserie gegeben ist. Besonders bevorzugt ist dabei, wenn der Metalleinsatz einschließlich Rahmen, Befestigungshülse und Anbindung aus einem gemeinsamen metallischen Material einteilig gefertigt, vorzugsweise als Aluminium-Druckguß-Teil gebildet sind.

Die Anbindung zwischen Rahmen und Befestigungshülse ist in der Breite kleiner als im Bereich der Befestigungshülse, um eine weitgehende mechanische Entkopplung zu erreichen. Als Breite wird hierbei die Größe des Querschnitts der Anbindung parallel zur Leiterplattenebene verstanden.

Sofern auf die elektrische Masseanbindung verzichtet werden kann und eine noch stärkere mechanische Entkopplung erforderlich ist, können dennoch die Befestigungshülsen zusammen mit dem Metalleinsatz einstückig gefertigt sein, indem die Anbindung zwischen Rahmen und Befestigungshülse an jeweils einer Solltrennstelle nicht vom Kunststoff umspritzt und nach dem Umspritzen an dieser/diesen Stelle(n) durchtrennt wird. Vorzugsweise weist der Metalleinsatz neben dem Rahmen auch zumindest eine vollflächige metallische Seitenwand auf.

In einer bevorzugten Ausgestaltung bildet Kunststoffumspritzung einen Kunststoffrahmen, welcher räumlich zwischen dem Rahmen des Metalleinsatzes und den Befestigungshülsen als auch dem zweiten Gehäuseteil und/oder einem Träger für das Gehäuse angeordnet ist.

Die Erfindung wird nachfolgend anhand von Ausführungsbeispielen unter Bezugnahme auf die Figuren näher erläutert. Es zeigen:
Figur 1 ein erstes Ausführungsbeispiel eines mit Kunststoff umspritzten Metalleinsatzes als Gehäuseteil mit Montageflansch
Figur 2A Metalleinsatz gemäß Figur 1 vor dem Umspritzen mit Kunststoff
Figur 2B Kunststoffumspritzung alleingestellt
Figur 3 Ansicht auf das Gehäuseteil gemäß Figur 1 von außen auf den Deckel
Figur 4A Ausführungsbeispiel einer entkoppelten Anbindung zwischen Metalleinsatz und Befestigungshülse im Montageflansch
Figur 4B Dämpfungselement auf den Montagedomen im Gehäuseteil
Figur 5A weitere Ausgestaltung der Gesamtbaugruppe
Figur 5B weitere Ausgestaltung der Gesamtbaugruppe

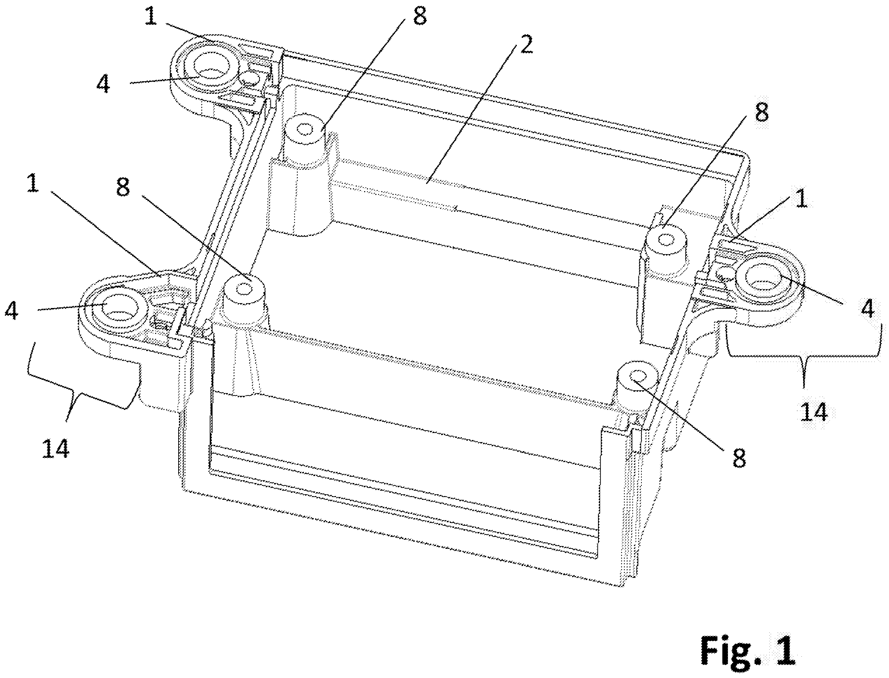

Figur 1 zeigt das Gehäuseteil mit dem Montageflansch 14 und einem Metalleinsatz 2 sowie einer Kunststoffumspritzung 1, wobei hier insgesamt 3 Montageflansche 14 vorgesehen sind, wobei in jedem von diesem Montageflanschen 14 jeweils eine Befestigungshülse 4 angeordnet ist.

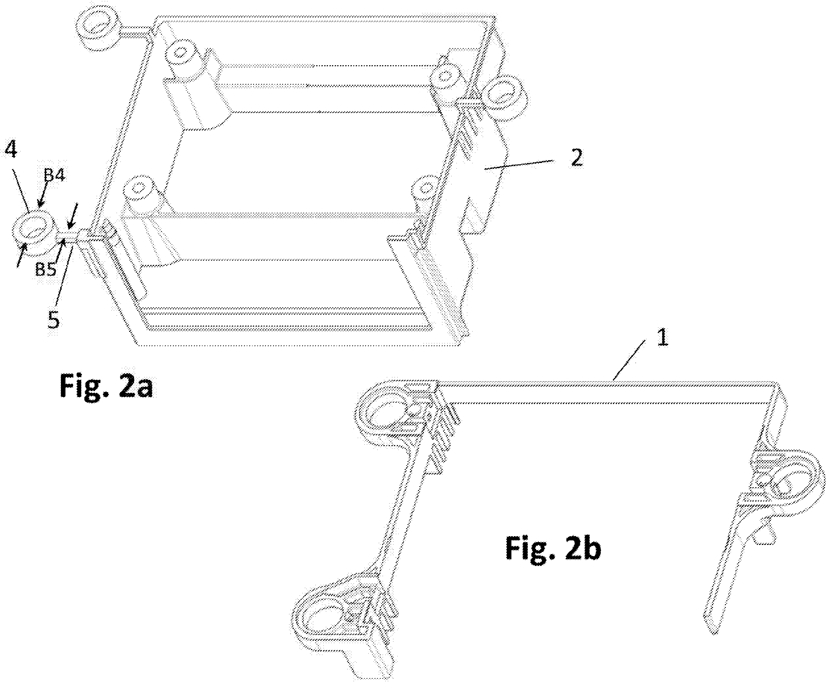

Figur 2A zeigt nun eine besonders bevorzugte Ausgestaltung des Metalleinsatzes 2, an welchem einstückig Anbindungen 5 zu den jeweiligen Befestigungshülsen 4 ausgeformt sind. Eine solche einteilige Ausbildung kann beispielsweise durch Aluminium-Druckguss gut gefertigt und als ein Stück nachfolgend vom Kunststoff umspritzt werden.

Die Anbindungen 5 sind zunächst elektrisch leitend, um über die hier ebenfalls metallischen Befestigungshülsen 4 an die Fahrzeugkarosserie einen Massekontakt und damit eine Erdung des Metalleinsatzes 2 zu ermöglichen. Wird zudem die Leiterplatte elektrisch leitend mit dem Metalleinsatz 2 verbunden, kann der Massekontakt auch zur Erdung der Leiterplatte und damit der elektronischen Baugruppe dienen, ohne dass es eines separaten Massekontakts im Stecker bedarf.

Die Breite B5 der Anbindungen 5 sind andererseits deutlich dünner ausgestaltet als die Breite B4 der Befestigungshülse 4, vorzugsweise die Anbindungen 5 sogar gebogen und teilelastisch federnd, um eine weitgehende mechanische Entkopplung zwischen dem Metalleinsatz 2 einerseits und dem im Montageflansch 14 nach der Montage der Baugruppe an einem Träger ja fest verspannten Befestigungshülsen 4 zu ermöglichen.

Als Breite B5 der Anbindung wird hierbei die Größe des Querschnitts der Anbindung parallel zur Leiterplattenebene verstanden.

Figur 2B zeigt nun explosionsartig und unter Ausblendung des Metalleinsatzes 2 allein die Formgebung der Kunststoffumspritzung 1, welche zum einen die Montageflansche 14 bildet und darüber hinaus vorzugsweise eine Art Kunststoffrahmen bildet, welcher räumlich zwischen dem Rahmen des Metalleinsatzes und den Befestigungshülsen angeordnet ist. In der Figur 2B gezeigt, muss dabei der Kunststoffrahmen keinesfalls geschlossen sein, sondern kann durchaus auch unterbrochen, beispielsweise wie hier gezeigt einseitig zum Steckerbereich hin offen sein.

Welche der Seitenwände bzw. ob die Deckelfläche 11 dieses Gehäuseteils dabei aus der Kunststoffumspritzung 1 oder dem Metalleinsatz 2 gebildet werden, kann anhand der Bedürfnisse des jeweiligen Anwendungsfall sehr weit reichend variiert werden.

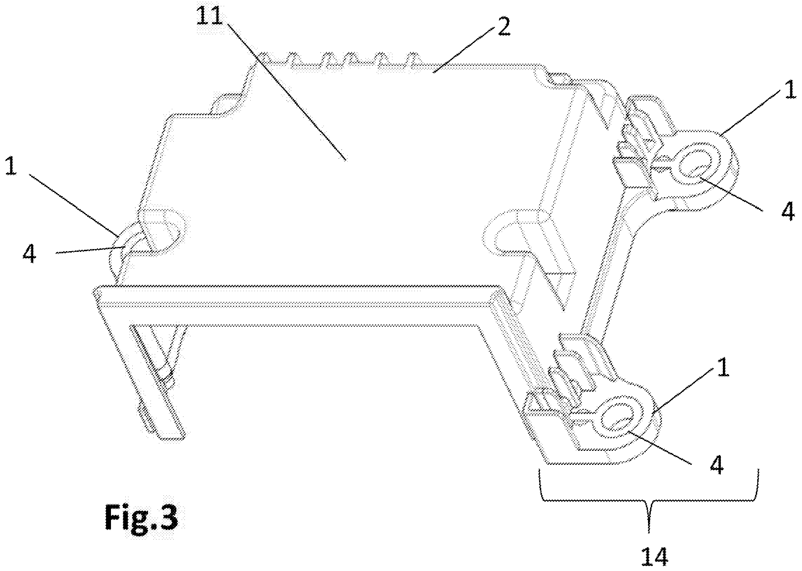

Figur 3 zeigt nun das Gehäuseteil gemäß der Figuren 1 und 2 aus einer anderen Perspektive mit Blick auf die aus dem Metalleinsatz 2 ausgebildete Deckelfläche 11.

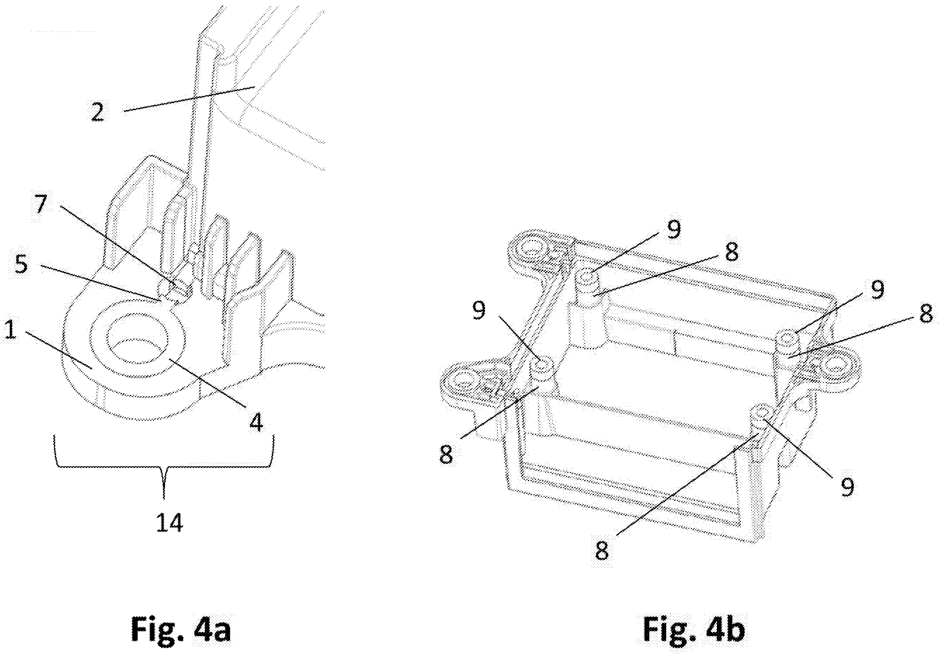

Figur 4A zeigt nun noch eine weitere besonders bevorzugte Ausgestaltung der Anbindung 5 zwischen dem Metalleinsatz 2 und der Befestigungshülse 4 im Montageflansch 14. So ist die Anbindung 5 in diesem Ausführungsbeispiel nicht gerade, sondern an Position 7 abgewinkelt geformt und kann in dieser Form Impulse und Erschütterungen federähnlich elastisch ausgleichen. Zudem weist die Kunststoffumspritzung 1 an dieser Position 7 eine entsprechende Aussparung auf.

Diese Verbindungen zwischen dem Metalleinsatz und den Buchsen können hinsichtlich der Vermeidung der Weiterleitung von Störsignalen optimiert werden (z.B. in der Dicke/Breite, Bogenkontur, ...), um sie möglichst weich auszuführen. Sollten durch die verbliebenen metallischen Verbindungen trotzdem Störsignale eingeleitet werden, können diese Anbindungen 5 an dieser Position 7 je nach Bedarf durchtrennt und der Metalleinsatz 2 somit noch stärker mechanisch entkoppelt werden. Für den Fall, dass alle Verbindungen 5 durchtrennt werden müssen, kann der Verlust der elektrischen Masseanbindung durch Einbringen z.B. eines Federstiftes wieder hergestellt werden.

Figur 4B zeigt eine weitere Dämpfungsmaßnahme, bei welcher auf den Verschraubdom 8, welche hier in den Ausführungsbeispielen aus der Deckelfläche 11 ragt, zur Leiterplatte hin Dämpfungselemente 9 vorgesehen sind. Diese Dämpfungselemente 9 können vorzugsweise aus dem Material der Kunststoffumspritzung 1 und in gleichem Fertigungsschritt mit dieser Umspritzung gefertigt werden.

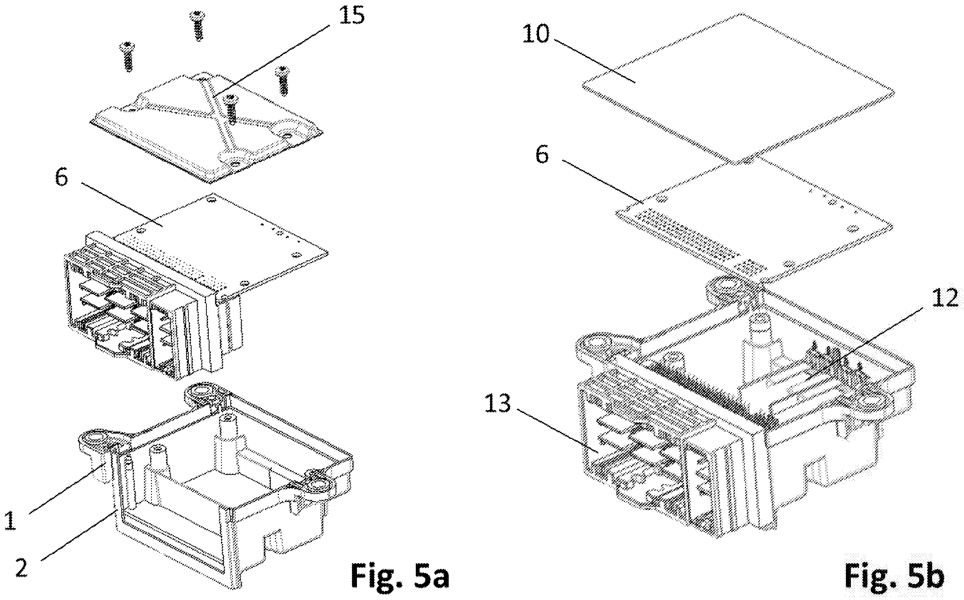

Die Figur 5A zeigt nun ein Ausführungsbeispiel der kompletten Baugruppe der kompletten Baugruppe bestehend aus dem Hybrid-Gehäuseteil mit Metalleinsatz 2 und Kunststoffumspritzung 1 sowie einer Leiterplatte 6, an welcher ein Steckerbereich zur elektrischen Kontaktierung angeordnet ist. Verschlossen wird das Gehäuseteil durch einen Schraubdeckel 15, welcher beispielsweise auch metallisch ausgebildet sein kann.

Figur 5B zeigt hingegen eine Ausgestaltung mit noch weitergehender bauliche Integration, bei welcher aus der Kunststoffumspritzung 1 auch der Steckerkragen 13 als auch Halteelemente für im Gehäusedeckel 11 befestigte Kondensatoren 12 ausgebildet sind, wobei die Steckerpins aus dem Steckerkragen 13 als auch die elektrischen Kontakte der Kondensatoren 12 als Einpresspins ausgestaltet und die Leiterplatte 6 auf diese Einpresspins gepresst und nachfolgend das Gehäuseteil durch einen Deckel ziehen verschlossen wird, wobei dieser Deckel ziehen vorzugsweise ein Grundstoffdeckel sein kann, welcher dann auch durch Laser-oder Reibschweißen, kleben oder vergleichbare Verbindungstechniken sogar feuchtigkeitsundurchlässig abgeschlossen werden kann.

Auch in diesen beiden Ausgestaltungen wird nochmals deutlich, dass das Verhältnis zwischen Kunststoffumspritzung 1 und Metalleinsatz 2 je nach Anwendungsfall sehr flexibel variiert werden kann.

Dieses Hybrid-Gehäuseteil aus Metalleinsatz und Kunststoffumspritzung eignet sich insbesondere für Steuergeräte für Insassenschutzeinrichtungen und realisiert die widersprüchlichen Anforderungen einer Entkopplung von Sensoren, insbesondere MEMS-Sensoren von störenden mechanischen Vibrationen über die Anbindung durch Kunststoffflansche einerseits bei gleichzeitiger Stabilität des Gehäuses im Crashfall andererseits.

Dieses Hybrid-Gehäuseteil kann als multifunktionales Einlegeteil über Druckguss oder alternativ Tiefziehblech erzeugt werden und ermöglicht zudem eine Teilereduzierung in der Fertigung durch Integration der Befestigungsbuchse in den Druckguss des Metalleinsatzes.

Sofern erforderlich, kann zudem ein Freistanzen der Anbindung Buchse - Gehäuse im Druckguss bei Bedarf als Filterfunktion , quasi "Hochfrequenzfalle" wirken.

Die sicherheitsrelevante Elektronik wird durch ein robustes Metallgehäuse bzw. dem Metalleinsatz geschützt und kann durch Abbrechen der Montageflansche im Crash entkoppelt werden, ohne dass der elektronische Datenrekorder gestört würde, sondern weiter intakt, vorzugsweise weiter auslesbar bleibt, zumindest kein Datenverlust eintritt.

Es ist ein wasserdichtes Gehäuse möglich durch Abdichten mit Deckel und damit IPx8-Klasse. Es ist ein Hot Air Riveting Mechanikkonzept realisierbar.

Durch die Kunststoffumspritzung kann eine Integration von Halteelementen für Kondensatoren im Gehäusedeckel oder/und ein integrierter Steckerbereich realisiert werden, ohne komplett auf die Sicherheit durch ein Metallgehäuse bzw. dem Metalleinsatz verzichten zu müssen.

Durch Erhöhung des Anteils an Kunststoff zu Druckguß kann Gewicht eingespart werden und eine Laserbeschriftung an entsprechenden Kunststoffabschnitten der Kunststoffumspritzung 1 erfolgen.

Trotzdem bleibt eine integrierte Masseanbindung und eine gegenüber einem reinen Kunststoffgehäuse bessere Ableitung der Verlustwärme über den Metalleinsatz im Gehäuseteil möglich.

## Patentansprüche

1. Zweiteiliges Gehäuse zur Aufnahme einer elektronischen Baugruppe (6), wobei an zumindest einem Gehäuseteil zumindest ein Montageflansch (14) und in diesem Montageflansch (14) eine metallische Befestigungshülse (4) vorgesehen ist, wobei dieses Gehäuseteil einen Metalleinsatz (2) aufweist, welcher zumindest einen Rahmen um die einzuschließende Baugruppe (6) bildet und welcher zumindest teilweise mit Kunststoff (1) umspritzt ist, wobei
der Rahmen des Metalleinsatzes (2) und die zumindest eine Befestigungshülse (4) über eine elektrisch leitfähige Anbindung (5) mit dem Rahmen des Metalleinsatzes (2) verbunden ist, und
der Metalleinsatz (2) einschließlich Rahmen, Befestigungshülse(n) (4) und Anbindung(en) (5) aus einem gemeinsamen metallischen Material einteilig gefertigt ist, **dadurch gekennzeichnet, dass** die Breite (B5) der Anbindung (5) zwischen Rahmen (2) und Befestigungshülse (4) dünner ist als die Breite (B4) der Befestigungshülse (4).

2. Gehäuse nach Anspruch 1, **dadurch gekennzeichnet, dass** die Anbindung (5) zwischen Rahmen und Befestigungshülse an einer Solltrennstelle (7) nicht vom Kunststoff umspritzt und nach dem Umspritzen an dieser Stelle durchtrennt ist.

3. Gehäuse nach Anspruch 1, **dadurch gekennzeichnet, dass** der Metalleinsatz (2) neben dem Rahmen auch zumindest eine vollflächige metallische Wand (11) aufweist.

4. Gehäuse nach einem der vorangehenden Ansprüche, **dadurch gekennzeichnet, dass** die Kunststoffumspritzung (1) einen Kunststoffrahmen bildet, welcher vorzugsweise räumlich zwischen dem Rahmen des Metalleinsatzes und den Befestigungshülsen oder/und zwischen dem Rahmen des Metalleinsatzes als auch dem zweiten Gehäuseteil und/oder einem Träger für das Gehäuse angeordnet ist.

5. Gehäuse nach einem der vorangehenden Ansprüche, **dadurch gekennzeichnet, dass** zwischen Montageflansch (14) und restlichem Gehäuseteil, insbesondere dem Metalleinsatz (2), eine Sollbruchstelle in der Kunststoffumspritzung (1) vorgesehen ist.

6. Gehäuse nach einem der vorangehenden Ansprüche, **dadurch gekennzeichnet, dass** der Metalleinsatz (2) einschließlich Rahmen, Befestigungshülse(n) (4) und Anbindung(en) (5) als Aluminium-Druckguß-Teil gebildet ist.

## Claims

1. A two-part housing for receiving an electronic assembly (6), wherein at least one mounting flange (14) is provided on at least one housing part and a metal attachment bushing (4) is provided in this mounting flange (14),
wherein said housing part has a metal insert (2) which forms at least one frame around the assembly (6) to be inserted, and which is overmolded at least partially with plastic (1),
wherein the frame of the metal insert (2) and the at least one attachment bushing (4) is connected to the frame of the metal insert (2) via an electrically conducting connection (5), and the metal insert (2) including the frame, attachment bushing(s) (4) and connection(s) (5) are produced as a single part from a common metal material,
**characterized in that** the width (B5) of the connection (5) between the frame (2) and attachment bushing (4) is thinner than the width (B4) of the attachment bushing (4).

2. The housing according to Claim 1, **characterized in that** the connection (5) between the frame and attachment bushing is not overmolded by the plastic at a nominal cutting line (7) and is cut at this point following the overmolding.

3. The housing according to Claim 1, **characterized in that** the metal insert (2), in addition to the frame, also has at least one all-over metal wall (11).

4. The housing according to any one of the preceding claims, **characterized in that** the plastic overmolding (1) forms a plastic frame which is preferably spatially arranged between the frame of the metal insert and the attachment bushings and/or between the frame of the metal insert and the second housing part and/or a carrier for the housing.

5. The housing according to any one of the preceding claims, **characterized in that** a predetermined breaking point is provided in the plastic overmolding (1) between the mounting flange (14) and remaining housing part, in particular the metal insert (2).

6. The housing according to any one of the preceding claims, **characterized in that** the metal insert (2) including the frame, attachment bushing(s) (4) and connection(s) (5) are formed as aluminum die-cast components.

## Revendications

1. Boîtier en deux parties destiné à recevoir un module électronique (6), une bride de montage (14) étant prévue sur au moins une partie de boîtier et une douille de fixation (4) métallique étant prévue dans cette bride de montage (14),
cette partie de boîtier présentant un élément en métal (2), lequel forme au moins un cadre autour du module devant être contenu (6) et lequel est surmoulé au moins partiellement avec une matière plastique (1),
le cadre de l'élément en métal (2) et l'au moins une douille de fixation (4) étant reliés par une connexion électriquement conductrice (5) avec le cadre de l'élément en métal (2), et
l'élément en métal (2), avec cadre, douille(s) de fixation (4) et connexion(s) (5) étant fabriqué d'une pièce dans un matériau métallique commun,
**caractérisé en ce que** la largeur (B5) de la connexion (5) entre le cadre (2) et la douille de fixation (4) étant inférieure à la largeur (B4) de la douille de fixation (4).

2. Boîtier selon la revendication 1, **caractérisé en ce que** la connexion (5) entre le cadre et la douille de fixation n'est pas surmoulée avec une matière plastique à un point de rupture prescrit (7) et est sectionnée après le surmoulage au niveau de ce point.

3. Boîtier selon la revendication 1, **caractérisé en ce que** l'élément en métal (2) présente aussi au moins une paroi métallique sur toute la surface (11), en plus du cadre.

4. Boîtier selon l'une quelconque des revendications précédentes, **caractérisé en ce que** le surmoulage en matière plastique (1) forme un cadre en matière plastique, lequel est disposé de préférence spatialement entre le cadre de l'élément en métal et les douilles de fixation et/ou entre le cadre de l'élément en métal et aussi la deuxième partie de boîtier et/ou un support pour le boîtier.

5. Boîtier selon l'une quelconque des revendications précédentes, **caractérisé en ce qu'**un point de rupture prescrit est prévu dans le surmoulage en matière plastique (1) entre la bride de montage (14) et le reste de la partie de boîtier, en particulier l'élément en métal (2).

6. Boîtier selon l'une quelconque des revendications précédentes, **caractérisé en ce que** l'élément en métal (2) avec cadre, douille(s) de fixation (4) et connexion(s) (5) est formé comme pièce en aluminium coulé sous pression.
